# FASCICULE DE BREVET EUROPEEN

(11) **EP 2 434 638 B1**
(45) Date de publication et mention de la délivrance du brevet: **31.12.2014**
(21) Numéro de dépôt: 11180950.5
(22) Date de dépôt: 12.09.2011
(51) Int. Cl.: H03B 5/00, H03B 5/18, H03B 27/00

(54) **Oscillateur couplé contrôlé par la phase**
Phasenkontrollierter gekoppelter Oszillator
Phase-controlled coupled oscillator

(30) Priorité: 24.09.2010 FR 1057709
(43) Date de publication de la demande: 28.03.2012
(73) Titulaire: Magajna, Patrick, 91160 Longjumeau (FR)
(72) Inventeur: Magajna, Patrick, 91160 Longjumeau (FR)
(74) Mandataire: Pontet Allano & Associes

(56) Documents cités:
- US-A- 4 808 936
- US-A1- 2006 097 801
- US-B1- 6 690 243

## Description

La présente demande concerne un oscillateur permettant de générer un signal électrique de fréquence réglable.

Le domaine de l'invention est le domaine des circuits électroniques et en particulier, des circuits électroniques intégrés utilisés dans les domaines des radiofréquences et des hyperfréquences, par exemple dans des systèmes de communication.

Dans les domaines radiofréquence et hyperfréquence, la méthode la plus utilisée afin d'obtenir un oscillateur réglable en fréquence, consiste à modifier la caractéristique phase-fréquence du résonateur

On peut citer notamment les oscillateurs qui sont conçus autour d'un ou de plusieurs varactors (ou capacité variable commandée en tension).

Or ce type d'élément ne permet pas, en général, une variation de fréquence supérieure à une octave. De plus, si on souhaite intégrer totalement l'oscillateur, le plus souvent la technologie utilisée lors de la conception du circuit intégré obéit à des choix qui ne sont pas optimisés, afin d'obtenir une variation maximale de la valeur de la capacité du varactor. La capacité variable ne permet pas alors d'obtenir une variation de fréquence sur une large bande de fréquence ou doit être positionnée à l'extérieur du circuit intégré.

De plus l'introduction de composants variables dans le résonateur crée des pertes, ce qui diminue le facteur de qualité du résonateur chargé.

Il est fait référence à l'état de la technique antérieure pertinent, notamment le document US2006/097801 qui divulgue un oscillateur couplé en quadrature ainsi que le document US 4 808 936 qui décrit un circuit de décalage de phase à base de multiplication et sommation d'un signal oscillation.

Un but de la présente invention est de remédier aux inconvénients précités.

Un autre but de l'invention est de proposer un oscillateur permettant d'obtenir une plage de variation de la fréquence plus large que les oscillateurs actuels.

Un autre but de l'invention est de proposer un oscillateur, qui permet d'obtenir un signal variable en fréquence, qui améliore le bruit.

Enfin, un autre but de l'invention est de proposer un oscillateur pouvant être totalement intégrable.

Pour atteindre au moins un de ces buts, l'invention propose un oscillateur pour générer un signal de fréquence ajustable, ledit oscillateur comprenant un système bouclé, dit principal, ledit système bouclé principal comprenant :
- un dispositif de déphasage, dit principal, comprenant au moins une cellule de déphasage, dite principale, d'un signal, dit principal, d'une valeur de déphasage ajustable, ledit signal principal étant un signal cosinus ou un signal sinus,
- au moins un moyen pour ajuster le déphasage réalisé par ledit dispositif de déphasage et
- un résonateur, dit principal, dont l'entrée est reliée à la sortie dudit dispositif de déphasage principal et dont la sortie est reliée à l'entrée dudit dispositif de déphasage principal,
ledit système bouclé principal fournissant un signal dont la fréquence est fonction de ladite valeur de déphasage.

Afin que des oscillations s'établissent au sein de l'oscillateur, un des critères définis par la théorie implique qu'un déphasage multiple entier de 2π existe dans le système bouclé. Le dispositif de déphasage imposant un déphasage réglable dans le système bouclé, le résonateur introduit alors un déphasage complémentaire; tel que la somme de ces deux déphasages soit un multiple entier de 2π. Le déphasage complémentaire introduit par le résonateur défini alors, par l'intermédiaire de la caractéristique phase-fréquence de celui-ci, la fréquence d'oscillation.

Ainsi, l'invention propose un oscillateur fournissant un signal dont la fréquence est ajustée par un déphasage. L'oscillateur selon l'invention permet donc de réaliser un ajustement/une variation de la fréquence sans modifier la caractéristique phase fréquence du résonateur utilisé, notamment sans modifier la valeur d'un élément composant l'oscillateur, tel que par exemple un élément capacitif et/ou un élément inductif.

La fréquence du signal fourni/généré par l'oscillateur selon l'invention est directement ajustée par le déphasage appliqué par le dispositif de déphasage.

L'oscillateur selon l'invention peut être complètement intégrable.

Par ailleurs, l'oscillateur ne comporte pas d'élément capacitif dont la valeur peut être modifiée.

Par ailleurs, la plage de variation de la fréquence est directement dépendante de la plage de variation de la valeur de déphasage. Par exemple, une plage de variation de la valeur de déphasage de 180° ou de 360° permet d'obtenir, avec l'oscillateur selon l'invention, une plage de variation de la fréquence plus large que celle obtenue avec les oscillateurs actuels.

L'utilisation d'un dispositif de déphasage combiné à un résonateur permet d'obtenir un signal de fréquence variable avec moins de bruit.

Avantageusement, le dispositif de déphasage principal peut comprendre plusieurs cellules de déphasage, montées en série, chaque cellule de déphasage définissant un niveau de déphasage.

L'utilisation de plusieurs cellules de déphasage permet, en disposant des cellules de déphasage présentant une (des) petite(s) plage(s) de déphasage, d'obtenir une grande plage de déphasage « globale » pour le dispositif de déphasage principal et ainsi de disposer d'une grande plage de variation de la fréquence du signal en sortie de l'oscillateur.

L'utilisation de plusieurs cellules de déphasage permet également d'obtenir plusieurs moyens indépendants pour ajuster le déphasage.

Dans la présente demande, le verbe « relier » désigne une connexion directe ou indirecte entre deux éléments.

Avantageusement, l'au moins un moyen pour ajuster le déphasage réalisé par ledit dispositif de déphasage peut comprendre :
- au moins un moyen d'ajustement commun à toutes les cellules de déphasage, chacune desdits cellules de déphasage réalisant un déphasage identique, ou
- au moins un moyen d'ajustement associé à chaque cellule de déphasage et permettant d'ajuster le déphasage réalisé par chaque cellule de déphasage indépendamment, ou
- au moins un moyen d'ajustement commun à plusieurs cellules de déphasage, réalisant un déphasage identique pour ces cellules de déphasage, les autres cellules de déphasage étant ajustées par d'autres moyens d'ajustement

Selon une version particulièrement avantageuse nullement limitative, l'au moins un moyen de déphasage peut être réduit à une ligne entrant dans une ou plusieurs cellules de déphasage et prévue pour véhiculer un signal de commande de déphasage, généré par un moyen externe à l'oscillateur, ce signal de commande faisant varier le déphasage dans la ou les cellules de déphasage. Dans ce cas, le signal de commande peut être par exemple une tension de commande.

Selon un mode de réalisation particulier, au moins une cellule de déphasage peut comprendre :
- un premier multiplieur fournissant un premier signal correspondant au produit du signal principal par une première tension de commande,
- un deuxième multiplieur fournissant un deuxième signal, correspondant au produit d'un signal, dit secondaire, par :
   - une deuxième tension de commande lorsque ledit signal principal est un sinus, ledit signal secondaire correspondant au signal principal avancé d'une valeur de 90 °, ou
   - une troisième tension de commande lorsque ledit signal principal est un cosinus, ledit signal secondaire correspondant au signal principal retardé d'une valeur de 90°
- un additionneur pour additionner lesdits premier et deuxième signaux fournis par lesdits multiplieurs ;
lesdites première, deuxième et troisième tensions de commande correspondant respectivement au cosinus, sinus et -sinus de la valeur de déphasage ajustable multipliés par la même constante.

Une telle cellule de déphasage permet de déphaser le signal principal d'une valeur de déphasage ajustable.

Ainsi, dans ce mode de réalisation particulièrement avantageuse de l'oscillateur selon l'invention, le déphasage d'un signal est réalisé par multiplication analogique de ce signal avec des tensions de commande, selon les relations trigonométriques suivantes :
▪ cos(wt)*cos(a)+sin(wt)*(-sin(a))= cos(wt+a), lorsque le signal dont la fréquence est ajustée est un cosinus et
▪ sin(wt)*cos(a)+cos(wt)*sin(a)= sin(wt+a), lorsque le signal dont la fréquence est ajustée est un sinus
avec w la pulsation du signal généré.

Dans ce mode de réalisation, les tensions de commande peuvent être :
- identiques pour toutes les cellules de déphasage : dans ce cas toutes les cellules de déphasage réalisent un déphasage de même valeur, ou
- différentes pour chaque cellule de déphasage: dans ce cas, chaque cellule de déphasage réalise un déphasage d'une valeur différente des autres cellules de déphasage.

Dans ce mode de réalisation, les tensions de commande modifient directement la phase du signal au sein du système bouclé.

Lorsque, le système bouclé principal comprend plusieurs cellules de déphasage, chacune des cellules de déphasage définissant un niveau de déphasage, chaque cellule de déphasage reçoit en entrée un signal principal et un signal secondaire et fournit le signal principal déphasé. Ce signal principal déphasé devient le signal principal pour la cellule suivante.

Dans un mode de réalisation particulier, le signal secondaire peut être obtenu à partir du signal principal entrant dans chaque cellule de déphasage. Pour ce faire, l'oscillateur selon l'invention comprend en amont de chaque cellule de déphasage principale d'un niveau donné, un déphaseur constant, dont la caractéristique phase-fréquence présente un déphasage constant avec la fréquence et fournissant le signal secondaire pour ladite cellule de déphasage principale à partir du signal principal.

Lorsque le signal principal est un cosinus, le déphaseur constant fournit un sinus de même amplitude et de même fréquence que le signal principal. Dans le cas où, le signal principal est un sinus, le déphaseur constant fournit un cosinus de même amplitude et de même fréquence que le signal principal.

Selon l'invention, le signal secondaire est obtenu à partir d'un deuxième système bouclé, dit secondaire. Ainsi, l'oscillateur selon l'invention comprend un deuxième système bouclé,
dit secondaire, ledit système bouclé secondaire comprenant :
- un deuxième dispositif de déphasage, dit secondaire comprenant autant de cellules de déphasage, dites secondaires, montées en série que de cellules de déphasage principales, la sortie du résonateur principal étant reliée à une entrée dudit dispositif de déphasage secondaire,
- un deuxième résonateur, dit secondaire, dont l'entrée est reliée à la sortie dudit dispositif de déphasage secondaire et la sortie est reliée à une entrée dudit dispositif de déphasage secondaire et à une entrée dudit dispositif de déphasage principal ;
une cellule de déphasage secondaire d'un niveau donné réalisant le même déphasage que la cellule de déphasage principale du même niveau et
la sortie d'une cellule de déphasage d'un niveau donné étant reliée à une entrée de la cellule de déphasage principale du niveau suivant, ladite cellule de déphasage secondaire dudit niveau fournissant le signal secondaire à ladite cellule de déphasage principale dudit niveau suivant.

Le système bouclé secondaire a pour rôle de fournir le signal secondaire à chaque cellule de déphasage. Pour ce faire, le système bouclé secondaire comprend autant de cellules de déphasage que le système bouclé principal, c'est-à-dire autant de niveaux de déphasage que le système bouclé principal. Chaque cellule de déphasage secondaire réalise un déphasage de même valeur que le déphasage réalisé par une cellule de déphasage principale de même niveau et fournit le signal secondaire à la cellule de déphasage principale du niveau suivant. Le signal secondaire utilisé par la cellule de déphasage principale du premier niveau de déphasage est obtenu à la sortie du résonateur du système bouclé secondaire.

Dans un mode de réalisation particulier du système bouclé secondaire :
- la sortie d'une cellule de déphasage principale d'un niveau de déphasage donné est reliée à une entrée de la cellule de déphasage secondaire du niveau suivant et
- chaque cellule de déphasage secondaire comprend :
   - un troisième multiplieur fournissant un signal correspondant au produit du signal secondaire par la première tension de commande,
   - un quatrième multiplieur fournissant un signal correspondant au produit :
      ▪ du signal principal par la deuxième tension de commande lorsque ledit signal est un cosinus,
      ▪ du signal principal par la troisième tension de commande lorsque ledit signal est un sinus,
   - un additionneur pour additionner les signaux fournis par lesdits troisième et quatrième multiplieurs et fournir ledit signal secondaire.

Ainsi, chaque cellule de déphasage secondaire utilise le signal principal pour obtenir le signal secondaire par multiplication analogique avec des tensions de commande. Les tensions de commande utilisées par les cellules de déphasage principale et secondaire d'un même niveau réalisent un déphasage de même valeur. Le signal secondaire est obtenu selon les relations trigonométriques suivantes réalisées par chacune des cellules de déphasage secondaires :
▪ cos(wt)*cos(a)+sin(wt)*(-sin(a))= cos(wt+a), lorsque le signal dont la fréquence est ajustée, c'est à dire le signal principal, est un sinus et
▪ sin(wt)*cos(a)+cos(wt)*sin(a)= sin(wt+a), lorsque le signal dont la fréquence est ajustée, c'est-à-dire le signal principal, est un cosinus.
avec w la pulsation.

Dans ce mode de réalisation, la sortie de chaque résonateur (principal et secondaire) est reliée à une entrée de chaque cellule de déphasage de premier niveau (principale et secondaire) et la sortie de chaque cellule de déphasage (principale et secondaire) d'un niveau de déphasage donné est reliée à une entrée de chaque cellule de déphasage (principale et secondaire) du niveau suivant.

Selon un mode de réalisation d'une cellule de déphasage, au moins un multiplieur d'une cellule de déphasage peut comprendre :
- un circuit de commutation comprenant quatre transistors montés deux à deux en paires différentielles et commandés par les tensions de commandes,
- un circuit amplificateur comprenant deux transistors montés en paires différentielles.

De plus, deux multiplieurs de deux cellules de déphasage d'un même niveau de déphasage et recevant les mêmes signaux peuvent comprendre :
- un circuit de commutation chacun, chaque circuit de commutation comprenant quatre transistors montés deux à deux en paires différentielles et
- un circuit amplificateur commun aux deux multiplieurs comprenant deux transistors montés en paires différentielles.

En outre, deux multiplieurs de deux cellules de déphasage d'un même niveau de déphasage et recevant des signaux différents peuvent comprendre :
- un circuit amplificateur chacun, chaque circuit amplificateur comprenant quatre transistors montés deux à deux en paires différentielles et
- un circuit de commutation commun comprenant deux transistors montés en paires différentielles.

Le fait de mettre en commun un circuit d 'amplification ou un circuit de commutation pour deux multiplieurs permet de diminuer le nombre de composants et donc de diminuer le coût de fabrication et les dimensions de l'oscillateur.

L'oscillateur selon l'invention peut également comprendre un diviseur de puissance, disposé en amont de chaque cellule de déphasage.

L'oscillateur selon l'invention peut également comprendre au moins un amplificateur disposé dans chaque système bouclé, plus particulièrement à l'entrée de chaque dispositif de déphasage.

Dans un mode de réalisation particulier, au moins un résonateur peut être une ligne de transmission, dont la caractéristique phase-fréquence est linéaire ou non.

Avantageusement, l'oscillateur selon l'invention peut être réalisé en technologie des circuits intégrés.

L'oscillateur selon l'invention est particulièrement adapté à une utilisation dans le domaine des radiofréquences ou micro-ondes ou dans le domaine de l'optique pour obtenir un signal de fréquence ajustable.

D'autres avantages et caractéristiques de l'invention apparaîtront à l'examen de la description détaillée d'un mode de mise en oeuvre nullement limitatif et des dessins annexés sur lesquels :
- la figure 1 est une représentation schématique d'un premier mode de réalisation d'un oscillateur selon l'invention ;
- la figure 2 est une représentation schématique d'un deuxième mode de réalisation d'un oscillateur selon l'invention ;
- la figure 3 est une représentation schématique d'un troisième mode de réalisation d'un oscillateur selon l'invention ;
- la figure 4 est une représentation schématique d'un quatrième mode de réalisation d'un oscillateur selon l'invention ;
- la figure 5 est une représentation schématique d'un cinquième mode de réalisation d'un oscillateur selon l'invention ;
- la figure 6 est une représentation schématique d'un sixième mode de réalisation d'un oscillateur selon l'invention ;
- la figure 7 est une représentation schématique d'une cellule de déphasage pouvant être mise en oeuvre dans les modes de réalisation des figures 3 à 6 ;
- les figures 8 et 9 sont des représentations schématiques de deux architectures plus compactes de cellules de déphasages pouvant être mises en oeuvre dans les modes de réalisation des figures 5 et 6 ; et
- la figure 10 est une représentation schématique d'un mode de réalisation préféré d'un oscillateur selon l'invention.

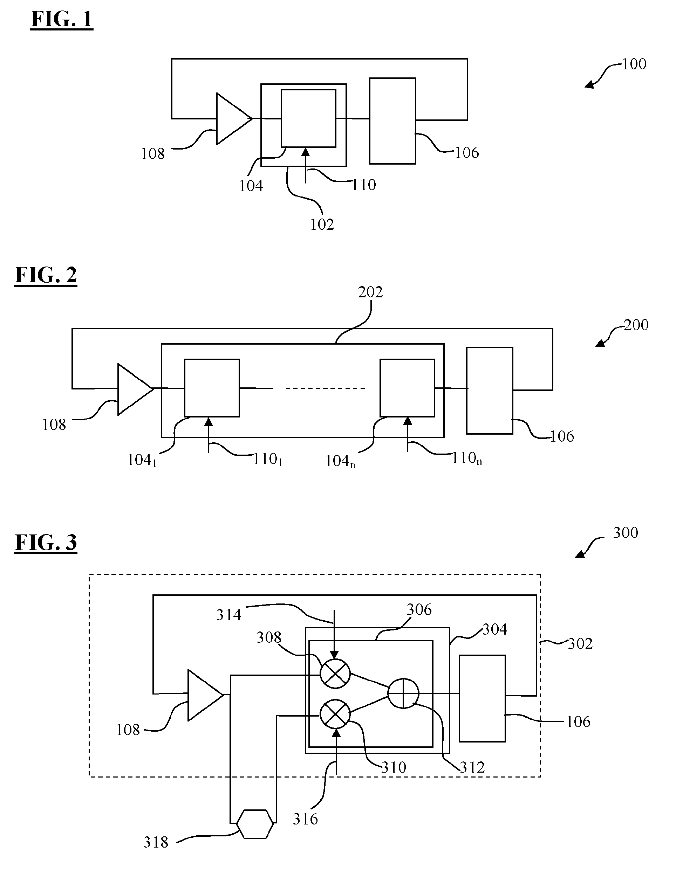

La figure 1 est une représentation schématique d'un premier mode de réalisation d'un oscillateur selon l'invention

L'oscillateur 100 représenté sur la figure 1 est une version très simplifiée d'un oscillateur selon l'invention. En effet, l'oscillateur 100 se réduit à un système bouclé comprenant un dispositif de déphasage 102 consistant en un déphaseur ajustable 104, un résonateur 106 disposé en aval du déphaseur 104 et un amplificateur 108 disposé en amont du déphaseur 104. La sortie du résonateur 106 est reliée directement à l'entrée de l'amplificateur 108.

L'oscillateur 100 comprend en outre des moyens pour ajuster le déphasage réalisé par le déphaseur 104. Dans l'exemple représenté sur la figure 1, ces moyens comprennent une ligne de commande, matérialisée par la flèche 110. La ligne de commande 110 permet d'ajuster le déphasage réalisé par le déphaseur 104 par une tension de commande par exemple.

Le résonateur 106 peut être, mais n'est pas limité à, une ligne de transmission dont la caractéristique phase-fréquence et linéaire.

La figure 2 est une représentation schématique d'un deuxième mode de réalisation d'un oscillateur selon l'invention.

L'oscillateur 200 est un système bouclé comprenant un dispositif de déphasage 202 comprenant une pluralité de déphaseurs ajustables 104₁-104ₙ montés en série, un résonateur 106 disposé en aval du dispositif de déphasage 202 et un amplificateur 108 disposé en amont du dispositif de déphasage 202. La sortie du résonateur 106 est reliée directement à l'entrée de l'amplificateur 108.

L'oscillateur 200 comprend en outre des moyens pour ajuster le déphasage réalisé par chaque déphaseur 104. Dans l'exemple représenté sur la figure 2, ces moyens comprennent une ligne de commande pour chaque déphaseur, matérialisée par les flèches 110₁, 110ₙ. Les lignes de commande 110₁-110ₙ permettent d'ajuster le déphasage réalisé par chaque déphaseur, respectivement, 104₁-104ₙ, par une tension de commande par exemple. La tension de commande peut être soit identique pour tous ou une partie des déphaseurs 104₁-104ₙ de sorte que le déphasage appliqué par une partie ou tous les déphaseurs 104₁-104ₙ est identique, soit différente pour chaque déphaseur 104₁-104ₙ de sorte que le déphasage appliqué par chaque déphaseur 104₁-104ₙ peut être différent et peut être ajusté individuellement et indépendamment des autres déphaseurs.

Chaque déphaseur 104₁-104ₙ définit un niveau de déphasage. Ainsi, le déphaseur 104₁ correspond au premier niveau de déphasage, le déphaseur 104ₙ correspond au niveau de déphasage n. Le système bouclé de l'oscillateur 200 comporte donc n niveaux de déphasage, avec n un entier positif.

La figure 3 est une représentation schématique d'un troisième mode de réalisation d'un oscillateur selon l'invention

L'oscillateur 300 comporte un système bouclé 302.

Le système bouclé 302 comporte un dispositif de déphasage 304 comprenant une cellule de déphasage 306, un amplificateur 108 disposé en amont du dispositif de déphasage 304 et un résonateur 106 disposé en aval du dispositif de déphasage 304.

La cellule de déphasage 306 comporte un premier multiplieur 308 fournissant un premier signal correspondant au produit du signal à déphaser, appelé dans la suite « signal principal », par une première tension de commande. La cellule de déphasage 306 comprend un deuxième multiplieur 310 fournissant un deuxième signal, correspondant au produit d'un signal, appelé signal secondaire, par :
- une deuxième tension de commande lorsque le signal principal est un sinus, le signal secondaire correspondant au signal principal avancé d'une valeur de 90 °, ou
- une troisième tension de commande lorsque le signal principal est un cosinus, le signal secondaire correspondant au signal principal retardé d'une valeur de 90° ;
les première, deuxième et troisième tensions de commande correspondant respectivement au cosinus, sinus et -sinus de la valeur de déphasage ajustable multipliés par la même constante

La cellule de déphasage 306 comprend en outre un additionneur 312 disposé en aval des multiplieurs 308 et 310 et additionnant les signaux fournis par les multiplieurs 308 et 310.

La première tension de commande est fournie à la cellule de déphasage 306 et plus particulièrement au multiplieur 308 par une ligne de commande matérialisée par la flèche 314.

La deuxième ou la troisième tension de commande est fournie à la cellule de déphasage 306 et plus particulièrement au multiplieur 310 par une ligne de commande matérialisée par la flèche 316.

L'oscillateur 300 comprend également un déphaseur constant, dont la caractéristique phase-fréquence présente un déphasage constant avec la fréquence, 318 disposé entre l'amplificateur 108 et la cellule de déphasage 306 et fournissant le signal secondaire à partir du signal principal. Le déphaseur 318 est prévu pour :
- retarder le signal principal de 90° lorsque le signal principal est un cosinus et
- avancer le signal principal de 90° lorsque le signal principal est un sinus.

La somme des signaux ainsi obtenus en sortie de l'additionneur 312 correspond au signal principal décalé de la valeur de déphasage selon les relations suivantes :
▪ cos(wt)*cos(a)+sin(wt)*(-sin(a))= cos(wt+a), lorsque le signal principal est un cosinus et
▪ sin(wt)*cos(a)+cos(wt)*sin(a)= sin(wt+a), lorsque le signal principal est un sinus.
« a » étant la valeur de déphasage ajustable et w étant la pulsation du signal généré.

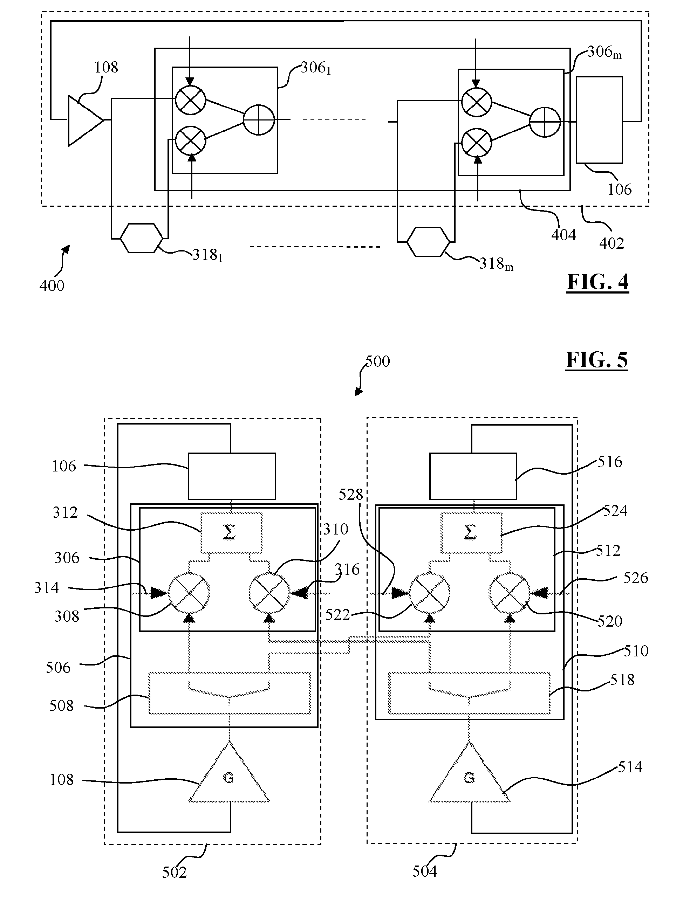

La figure 4 est une représentation schématique d'un quatrième mode de réalisation d'un oscillateur selon l'invention

L'oscillateur 400 comporte un système bouclé 402.

Le système bouclé 402 comporte un dispositif de déphasage 404 comprenant une pluralité de cellules de déphasage 306₁-306ₘ montées en série et définissant chacune un niveau de déphasage, un amplificateur 108 disposé en amont du dispositif de déphasage 404 et un résonateur 106 disposé en aval du dispositif de déphasage 404.

Chaque cellule de déphasage 306₁-306ₘ du dispositif de déphasage 404 est identique à la cellule de déphasage 306 de la figure 3. Chaque cellule de déphasage 306₁-306ₘ est prévue pour réaliser un déphasage sur le signal principal fourni par la cellule de déphasage précédente par multiplication analogique avec des tensions de commande. Les tensions de commande peuvent être :
- identiques pour l'ensemble ou une partie des cellules de déphasage 306₁-306ₘ : dans ce cas, ces cellules de déphasage réalisent le même déphasage sur le signal principal, ou
- différentes pour chaque cellule de déphasage 306₁-306ₘ : dans ce cas, chaque cellule de déphasage 306₁-306ₘ réalise un déphasage différent du signal principal.

Selon la configuration choisie, les tensions de commande peuvent être ajustées indépendamment pour chaque cellule de déphasage 306₁-306ₘ ou de manière commune pour toutes ou une partie des cellules de déphasage 306₁-306ₘ.

L'oscillateur 400 comprend également un déphaseur constant, 318₁-318ₘ pour chaque cellule de déphasage 306₁-306ₘ, disposé en amont de chaque cellule de déphasage 306₁-306ₘ et fournissant le signal secondaire à la cellule de déphasage 306 d'un niveau de déphasage donné à partir du signal principal reçu de la cellule de déphasage du niveau de déphasage précédent. Chaque déphaseur constant 318₁-318ₘ est identique au déphaseur constant 318 de la figure 3.

La figure 5 est une représentation schématique d'un cinquième mode de réalisation d'un oscillateur selon l'invention.

L'oscillateur 500 de la figure 5 comprend un premier système bouclé 502, appelé système bouclé principal et un deuxième système bouclé 504, appelé système bouclé secondaire.

Le système bouclé principal 502 comprend un amplificateur 108, un résonateur 106 et un dispositif de déphasage principal 506 comprenant une cellule de déphasage 306 identique à la cellule de déphasage 306 de la figure 3. Un diviseur de puissance 508 est disposé entre l'amplificateur 108 et la cellule de déphasage 306. Dans la suite de la description la ou les cellules de déphasage du dispositif de déphasage principal 506 seront appelée(s) cellule(s) de déphasage principale(s).

Le système bouclé secondaire 504 a pour rôle de fournir le signal secondaire utilisé par la cellule de déphasage principale 306 du système bouclé principal 502. Pour ce faire, le système bouclé secondaire 504 comporte un dispositif de déphasage 510, dit secondaire, comprenant une cellule de déphasage 512, dite secondaire, fournissant le signal secondaire par multiplication analogique avec des tensions de commande, un amplificateur 514 disposé en amont de la cellule de déphasage secondaire 512 et un résonateur 516 disposé en aval de la cellule de déphasage secondaire 512. La sortie du résonateur 516 est connectée à l'entrée de l'amplificateur 514.

Un diviseur de puissance 518 est disposé entre l'amplificateur 514 et la cellule de déphasage secondaire 512.

La cellule de déphasage secondaire 512 est identique à la cellule de déphasage principale 306 et comprend :
- un multiplieur 520 fournissant un signal correspondant au produit du signal secondaire, par la première tension de commande,
- un multiplieur 522 fournissant un signal correspondant au produit :
   ▪ du signal principal par la deuxième tension de commande lorsque ledit signal est un cosinus,
   ▪ du signal principal par la troisième tension de commande lorsque ledit signal est un sinus,
- un additionneur 524 pour additionner les signaux fournis par les multiplieurs 520 et 522 et fournir le signal secondaire.

La première tension de commande est fournie à la cellule de déphasage secondaire 512 par une ligne de commande matérialisée par la flèche 526. La deuxième ou la troisième tension de commande est fournie à la cellule de déphasage secondaire 512 par une ligne de commande matérialisée par la flèche 528.

Les première, deuxième et troisième tensions de commande utilisées par la cellule de déphasage principale 306 et la cellule de déphasage secondaire 512 sont identiques. Ainsi, les cellules de déphasages 306 et 512 appliquent le même déphasage respectivement au signal principal et au signal secondaire.

La somme des signaux ainsi obtenue en sortie de l'additionneur 524 correspond au signal secondaire décalé de la valeur de déphasage appliquée au signal principal par la cellule de déphasage principale 306 :
▪ cos(wt)*cos(a)+sin(wt)*(-sin(a))= cos(wt+a), lorsque le signal principal est un sinus et
▪ sin(wt)*cos(a)+cos(wt)*sin(a)= sin(wt+a), lorsque le signal principal est un cosinus.
avec « a » la valeur de déphasage et w la pulsation du signal généré.

Le signal principal et le signal secondaire sont chacun divisés en deux respectivement par les diviseurs de puissance 508 et 518 et fournis à chacune des cellules de déphasage principale 306 et secondaire 512.

Les systèmes bouclés principal et secondaire fournissent deux signaux en quadrature.

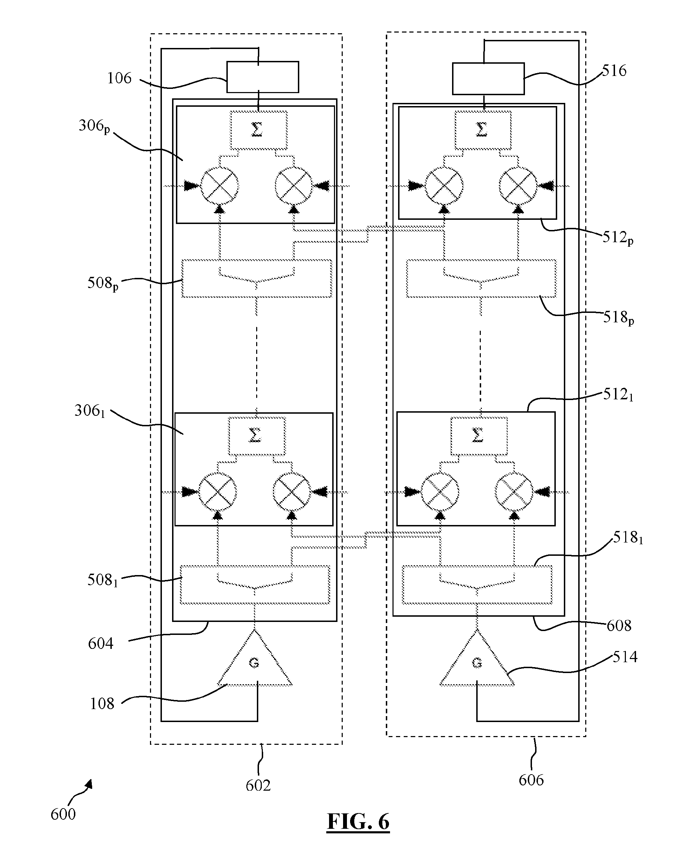

La figure 6 est une représentation schématique d'un sixième mode de réalisation d'un oscillateur selon l'invention

L'oscillateur 600 représenté sur la figure 6 comporte un système bouclé principal 602 comprenant un amplificateur 108, un résonateur 106 et un dispositif de déphasage principal 604 comprenant une pluralité de cellules de déphasage principales 306₁-306ₚ, montées en série et identiques à la cellule de déphasage 306 de la figure 3. Chaque cellule de déphasage principale 306₁-306ₚ définit un niveau de déphasage.

L'oscillateur 600 comporte également un système bouclé secondaire 606 comprenant un amplificateur 514, un résonateur 516 et un dispositif de déphasage secondaire 608 comprenant autant de cellules de déphasage secondaires 512₁-512ₚ, montées en série et identiques à la cellule de déphasage secondaire 512 de la figure 5, que de cellules de déphasage principales 306₁-306ₚ, chaque cellule de déphasage 512₁-512ₚ définissant un niveau de déphasage. Chaque cellule de déphasage secondaire 512₁-512ₚ d'un niveau de déphasage donné réalise un déphasage d'une valeur identique au déphasage réalisé par la cellule de déphasage principale 306₁-306ₚ du même niveau de déphasage.

Devant chaque cellule de déphasage principale 306₁-306ₚ est disposé un diviseur de puissance 508₁-508ₚ, divisant le signal principal provenant du niveau de déphasage précédent pour l'injecter dans la cellule de déphasage principale et la cellule de déphasage secondaire du niveau suivant.

Devant chaque cellule de déphasage secondaire 512₁-512ₚ, est disposé un diviseur de puissance 518₁-518ₚ, divisant le signal secondaire provenant du niveau de déphasage précédent pour l'injecter dans la cellule de déphasage principale et la cellule de déphasage secondaire du niveau suivant.

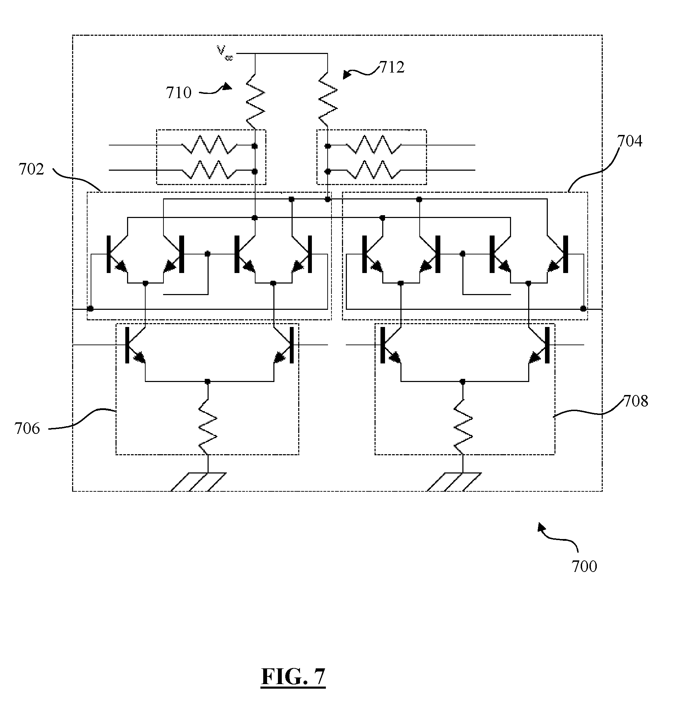

La figure 7 est une représentation schématique d'une cellule de déphasage pouvant être mise en oeuvre dans les modes de réalisation des figures 3 à 6 en tant que cellule de déphasage principale ou cellule de déphasage secondaire.

La cellule de déphasage 700 comporte, pour chaque multiplieur de la cellule de déphasage un circuit de commutation 702 et 704, comprenant chacun quatre transistors montés deux à deux en paires différentielles et commandés par les tensions de commandes. Chaque multiplieur comprend également un circuit amplificateur 706 et 708 comprenant deux transistors montés en paires différentielles et associées aux circuits de commutation, respectivement 702 et 704. Les résistances 710 et 712 insérées entre la ligne d'alimentation V_{cc} et les collecteurs des transistors effectuent l'opération de sommation des signaux et plus particulièrement l'addition des courants.

Lorsque deux multiplieurs de deux cellules de déphasage d'un même niveau utilisent les mêmes signaux, une architecture plus compacte peut être proposée pour réaliser ces deux multiplieurs.

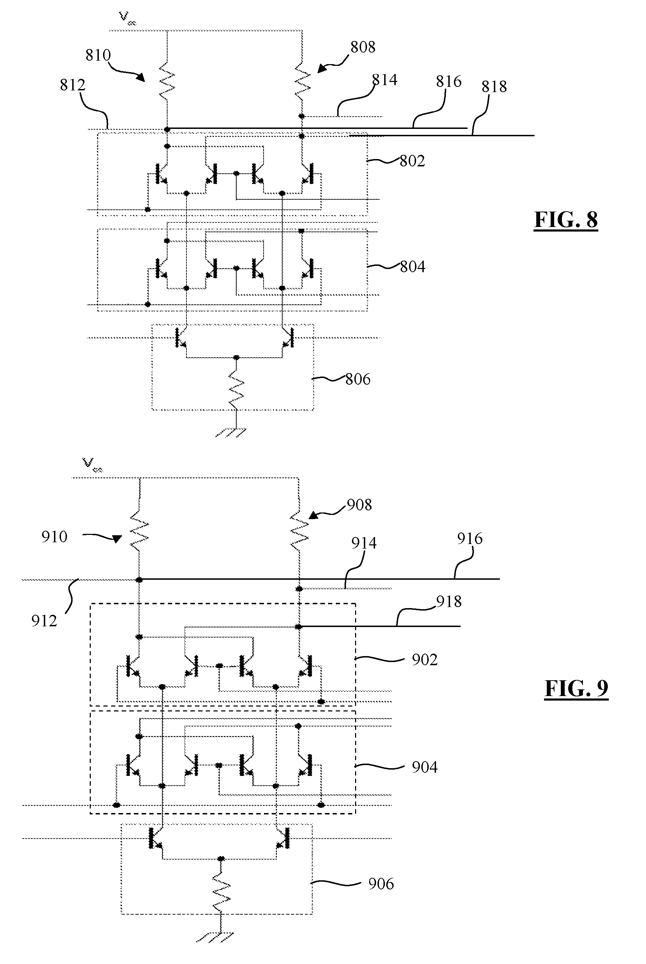

Ainsi, la figure 8 est une représentation schématique d'une telle architecture pouvant être mise en oeuvre dans les modes de réalisation des figures 5 et 6

Chacun des deux multiplieurs de deux cellules de déphasage d'un même niveau recevant les mêmes signaux comprennent un circuit de commutation 802 et 804, chaque circuit de commutation 802 et 804 comprenant quatre transistors montés deux à deux en paires différentielles et commandés par les tensions de commande. Selon l'architecture proposée en figure 8, un circuit amplificateur 806 commun est associé aux deux circuits de commutation 802 et 804, ce circuit amplificateur 806 comprenant deux transistors montés en paires différentielles. Les résistances 808 et 810 insérées entre la ligne d'alimentation V_{cc} et les collecteurs des transistors effectuent l'opération de sommation des signaux et plus particulièrement l'addition des courants.

Dans l'architecture représentée sur la figure 8, des connexions permettent d'une part de véhiculer, dans les résistances 808 et 810, les courants provenant de l'autre multiplieur de la même cellule de déphasage, d'autre part de véhiculer les tensions résultant de la sommation des signaux dans les résistances 808 et 810, soit vers des multiplieurs du niveau de déphasage suivant, soit vers le ou les résonateurs.

Ainsi, deux lignes de transmission 812 et 814 constituent chacune une connexion avec les cellules de déphasage de niveau de déphasage suivant ou le résonateur et véhiculent soit le signal principal soit le signal secondaire.

Deux autres lignes de transmission 816 et 818 véhiculent chacune le signal obtenu en sortie d'un multiplieur et qu'il faut sommer avec le signal obtenu en sortie de l'autre multiplieur d'une même cellule de déphasage.

Lorsque deux multiplieurs de deux cellules de déphasage d'un même niveau utilisent des signaux différents, une architecture plus compacte peut également être proposée pour réaliser ces deux multiplieurs.

Ainsi, la figure 9 est une représentation schématique d'une telle architecture pouvant être mise en oeuvre dans les modes de réalisation des figures 5 et 6.

Chacun des deux multiplieurs de deux cellules de déphasage d'un même niveau recevant des signaux différents comprennent un circuit d'amplification 902 et 904, chaque circuit d'amplification 902 et 904 comprenant quatre transistors montés deux à deux en paires différentielles et dont les bases sont reliées à un résonateur ou aux sorties des cellules de déphasage de niveau de déphasage précédent. Selon l'architecture proposée en figure 9, un circuit de commutation 906 commun est associé aux deux circuits d'amplification 902 et 904, ce circuit de commutation 906 comprenant deux transistors montés en paires différentielles.

Les résistances 908 et 910 insérées entre la ligne d'alimentation V_{cc} et les collecteurs des transistors effectuent l'opération de sommation des signaux et plus particulièrement l'addition des courants.

Dans l'architecture représentée sur la figure 9, des connexions permettent d'une part de véhiculer, dans les résistances 908 et 910, les courants provenant de l'autre multiplieur de la même cellule de déphasage, d'autre part de véhiculer les tensions résultant de la sommation des signaux dans les résistances 908 et 910, soit vers des multiplieurs du niveau de déphasage suivant, soit vers le ou les résonateurs.

Ainsi, deux lignes de transmission 912 et 914 constituent chacune une connexion avec les cellules de déphasage de niveau de déphasage suivant ou le résonateur et véhiculent soit le signal principal soit le signal secondaire.

Deux autres lignes de transmission 916 et 918 véhiculent chacune le signal obtenu en sortie d'un multiplieur et qu'il faut sommer avec le signal obtenu en sortie de l'autre multiplieur d'une même cellule de déphasage.

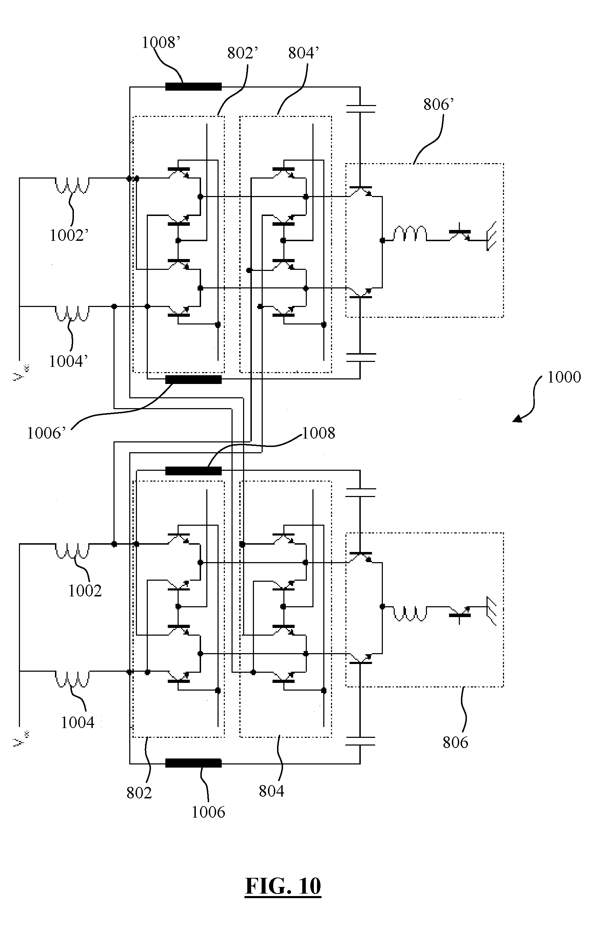

La figure 10 est une représentation d'un mode de réalisation préféré d'un oscillateur selon l'invention mettant en oeuvre l'architecture compacte décrite en référence à la figure 8.

L'oscillateur 1000 représentée en figure 10 comprend un seul niveau de déphasage comprenant deux cellules de déphasage, à savoir une cellule de déphasage principale et une cellule de déphasage secondaire.

Les résistances 808 et 810 d'une cellule de déphasage sont remplacées par des inductances. Ainsi, l'oscillateur 1000 comprend deux inductances 1002 et 1004 pour la cellule de déphasage principale et 1002' et 1004' pour la cellule de déphasage secondaire.

L'oscillateur 1000 comprend en outre deux circuits de commutation par cellule de déphasage, à savoir les circuits de commutation 802 et 804 pour la cellule de déphasage principale et les circuits de commutation 802' et 804' pour la cellule de déphasage secondaire.

Chaque cellule de déphasage comprend un circuit amplificateur, à savoir le circuit amplificateur 806 pour la cellule de déphasage principale et le circuit amplificateur 806' pour la cellule de déphasage secondaire. La résistance de chaque circuit amplificateur est également remplacée par une inductance.

Des résonateurs 1006 et 1008, qui sont des lignes de transmission, permettent de reboucler le signal issu de la cellule de déphasage principale à l'entrée de la cellule de déphasages principale.

De même, des résonateurs 1006' et 1008', qui sont des lignes de transmission, permettent de reboucler le signal issu de la cellule de déphasage secondaire à l'entrée de la cellule de déphasage secondaire.

Dans les exemples décrits, il est aussi possible de remplacer au moins l'une des résistances 710, 712, 908 et 910, par une impédance, possédant une partie imaginaire non nulle. Ces impédances peuvent correspondre au moins en partie à tout ou partie du résonateur.

Bien sûr, l'invention n'est pas limitée aux exemples qui viennent d'être décrits et de nombreux aménagements peuvent être apportés à ces exemples sans sortir du cadre de l'invention.

## Revendications

1. Oscillateur (500, 600, 1000) pour générer un signal de fréquence ajustable, ledit oscillateur (500, 600, 1000) comprenant :
- un premier système bouclé (502,602), dit principal, ledit système bouclé principal comprenant :
- un dispositif de déphasage (506,604), dit principal, comprenant au moins une cellule de déphasage (306), dite principale, d'un signal, dit principal, d'une valeur de déphasage ajustable, chaque cellule de déphasage (306) définissant un niveau de déphasage, ledit signal principal étant un cosinus ou un sinus,
- un résonateur (106), dit principal, dont l'entrée est reliée à la sortie dudit dispositif de déphasage principal (506,604) et dont la sortie est reliée à une entrée dudit dispositif de déphasage principal (506,604) ;
- un deuxième système bouclé, dit secondaire, ledit système bouclé secondaire comprenant :
- un deuxième dispositif de déphasage (510, 608), dit secondaire comprenant autant de cellules de déphasage (512), dites secondaires, montées en série que de cellules de déphasage principales (306), réalisant le déphasage d'un signal, dit secondaire, de ladite valeur de déphasage, et
- un deuxième résonateur (516), dit secondaire, dont l'entrée est reliée à la sortie dudit dispositif de déphasage secondaire (510, 608) et dont la sortie est reliée à une entrée dudit dispositif de déphasage secondaire (510, 608) et à une entrée dudit dispositif de déphasage principal (506,604), et la sortie du résonateur principal (106) étant reliée à une entrée dudit dispositif de déphasage secondaire (510,608),
ledit oscillateur comprenant au moins un moyen pour ajuster le déphasage réalisé par chaque cellule de déphasage par multiplication de deux signaux en quadrature par deux signaux, dits de commande, et par sommation des signaux résultants;
**caractérisé en ce que**, pour chaque cellule de déphasage d'un desdits systèmes bouclés :
- l'un desdits signaux en quadrature est le signal principal, et
- l'autre desdits signaux en quadrature est le signal secondaire.

2. Oscillateur selon la revendication 1, **caractérisé en ce que** l'au moins un moyen pour ajuster le déphasage comprend :
- au moins un moyen d'ajustement commun à toutes les cellules de déphasage, chacune desdites cellules de déphasage réalisant un déphasage identique, ou
- au moins un moyen d'ajustement associé à chaque cellule de déphasage et permettant d'ajuster le déphasage réalisé par chaque cellule de déphasage indépendamment, ou
- au moins un moyen d'ajustement commun à plusieurs cellules de déphasage, réalisant un déphasage identique pour ces cellules de déphasage, les autres cellules de déphasage étant ajustées par d'autres moyens d'ajustement

3. Oscillateur (500,600, 1000) selon l'une quelconque des revendications précédentes, **caractérisé en ce qu'**une cellule de déphasage secondaire (512) d'un niveau donné réalise le même déphasage que la cellule de déphasage principale (306) du même niveau et la sortie d'une cellule de déphasage secondaire (512) d'un niveau donné est reliée à une entrée de la cellule de déphasage principale (306) du niveau suivant, ladite cellule de déphasage secondaire (512) dudit niveau donné fournissant le signal secondaire à ladite cellule de déphasage principale (306) dudit niveau suivant, la sortie d'une cellule de déphasage principale (306) d'un niveau donné est reliée à une entrée de la cellule de déphasage secondaire (512) du niveau suivant, ladite cellule de déphasage principale (306) dudit niveau donné fournissant le signal principal à ladite cellule de déphasage secondaire (512) dudit niveau suivant.

4. Oscillateur (500, 600, 1000) selon l'une quelconque des revendications précédentes, **caractérisé en ce qu'**au moins une cellule de déphasage principale comprend :
- un premier multiplieur (308) fournissant un premier signal correspondant au produit du signal principal par une première tension de commande,
- un deuxième multiplieur (310) fournissant un deuxième signal, correspondant au produit du signal secondaire, par :
- une deuxième tension de commande lorsque ledit signal principal est un sinus, ledit signal secondaire correspondant au signal principal avancé d'une valeur de 90 °, ou
- une troisième tension de commande lorsque ledit signal principal est un cosinus, ledit signal secondaire correspondant au signal principal retardé d'une valeur de 90°
- un additionneur (312) pour additionner lesdits premier et deuxième signaux fournis par lesdits multiplieurs (308,310) ;
lesdites première, deuxième et troisième tensions de commande correspondant respectivement au cosinus, sinus et -sinus de la valeur de déphasage ajustable multipliés par la même constante.

5. Oscillateur (500,600, 1000) selon l'une quelconque des revendications précédentes, **caractérisé en ce que** :
- la sortie d'une cellule de déphasage principale (306) d'un niveau de déphasage donné est reliée à une entrée de la cellule de déphasage secondaire (512) du niveau suivant,
- chaque cellule de déphasage secondaire (512) comprenant :
- un troisième multiplieur (520) fournissant un signal correspondant au produit du signal secondaire par la première tension de commande,
- un quatrième multiplieur (522) fournissant un signal correspondant au produit :
▪ du signal principal par la deuxième tension de commande lorsque ledit signal est un cosinus,
▪ du signal principal par la troisième tension de commande lorsque ledit signal est un sinus.
- un additionneur (524) pour additionner les signaux fournis par lesdits troisième et quatrième multiplieurs (520,522) et fournir ledit signal secondaire.

6. Oscillateur selon l'une quelconque des revendications 4 ou 5, **caractérisé en ce qu'**au moins un multiplieur d'une cellule de déphasage (700) comprend :
- un circuit de commutation (702,704) comprenant quatre transistors montés deux à deux en paires différentielles et commandés par les tensions de commandes,
- un circuit amplificateur (706,708) comprenant deux transistors montés en paires différentielles.

7. Oscillateur (1000) selon la revendication 6, **caractérisé en ce que** deux multiplieurs de deux cellules de déphasage d'un même niveau de déphasage et recevant les mêmes signaux comprennent :
- un circuit de commutation (802,804, 802', 804') chacun, chaque circuit de commutation (802,804, 802', 804') comprenant quatre transistors montés deux à deux en paires différentielles et
- un circuit amplificateur (806, 806') commun comprenant deux transistors montés en paires différentielles.

8. Oscillateur selon l'une quelconque des revendications 6 ou 7, **caractérisé en ce que** deux multiplieurs de deux cellules de déphasage d'un même niveau de déphasage et recevant des signaux différents comprennent :
- un circuit amplificateur (902,904) chacun, chaque circuit amplificateur (902,904) comprenant quatre transistors montés deux à deux en paires différentielles et
- un circuit de commutation (906) commun comprenant deux transistors montés en paires différentielles.

9. Oscillateur (500,600, 1000) selon l'une quelconque des revendications précédentes, **caractérisé en ce qu'**un diviseur de puissance (508,518) est disposé en amont de chaque cellule de déphasage (306,512).

10. Oscillateur (500,600, 1000) selon l'une quelconque des revendications précédentes, **caractérisé en ce qu'**il comprend au moins un amplificateur (108,514, 806, 806') disposé dans chaque système bouclé.

11. Oscillateur selon l'une quelconque des revendications précédentes, **caractérisé en ce qu'**au moins un résonateur (106,516) comprend une ligne de transmission.

12. Oscillateur (500,600) selon l'une quelconque des revendications précédentes, **caractérisé en ce qu'**il est réalisé en technologie des circuits intégrés.

13. Utilisation de l'oscillateur (500, 600) selon l'une quelconque des revendications précédentes dans le domaine des radiofréquences ou micro-ondes ou dans le domaine de l'optique.

## Patentansprüche

1. Oszillator (500, 600, 1000) zur Erzeugung eines Signals mit einstellbarer Frequenz, wobei der Oszillator (500, 600, 1000) umfasst :
- ein erstes geschleiftes, sogenanntes Hauptsystem (502, 602), wobei das geschleifte Hauptsystem umfasst:
- eine sogenannte Hauptphasenverschiebungsvorrichtung (506, 604), die wenigstens eine sogenannte Hauptzelle zur Phasenverschiebung (306) eines sogenannten Hauptsignals um einen einstellbaren Phasenverschiebungswert umfasst, wobei jede Phasenverschiebungszelle (306) eine Phasenverschiebungsstufe definiert, wobei das Hauptsignal ein Kosinus oder ein Sinus ist,
- einen sogenannten Hauptresonator (106), dessen Eingang mit dem Ausgang der Hauptphasenverschiebungsvorrichtung (506, 604) verbunden ist und dessen Ausgang mit einem Eingang der Hauptphasenverschiebungsvorrichtung (506, 604) verbunden ist;
- ein zweites geschleiftes, sogenanntes Nebensystem, wobei das geschleifte Nebensystem umfasst:
- ein zweite, sogenannte Nebenphasenverschiebungsvorrichtung (510, 608), die genauso viele in Reihe geschaltete sogenannte Nebenphasenverschiebungszellen (512) wie Hauptphasenverschiebungszellen (306) umfasst, die die Phasenverschiebung eines sogenannten Nebensignals um einen Phasenverschiebungswert durchführen, und
- einen zweiten, sogenannten Nebenresonator (516), dessen Eingang mit dem Ausgang der Nebenphasenverschiebungsvorrichtung (510, 608) verbunden ist und dessen Ausgang mit einem Eingang der Nebenphasenverschiebungsvorrichtung (510, 608) und mit einem Eingang der Hauptphasenverschiebungsvorrichtung (506, 604) verbunden ist, und wobei der Ausgang des Hauptresonators (106) mit einem Eingang der Nebenphasenverschiebungsvorrichtung (510, 608) verbunden ist,
wobei der Oszillator wenigstens ein Mittel umfasst, um die durch jede Phasenverschiebungszelle durchführte Phasenverschiebung durch Multiplikation von zwei Quadratursignalen mit zwei sogenannten Steuersignalen sowie durch Summieren der resultierenden Signale einzustellen;
**dadurch gekennzeichnet, dass** für jede Phasenverschiebungszelle von einem der geschleiften Systeme:
- das eine der Quadratursignale das Hauptsignal ist und
- das andere der Quadratursignale das Nebensignal ist.

2. Oszillator nach Anspruch 1, **dadurch gekennzeichnet, dass** das wenigstens ein Mittel zur Einstellung der Phasenverschiebung umfasst:
- wenigstens ein Einstellmittel, das allen Phasenverschiebungszellen gemein ist, wobei jede der Phasenverschiebungszellen eine identische Phasenverschiebung durchführt, oder
- wenigstens ein Einstellmittel, das jeder Phasenverschiebungszelle zugeordnet ist und das ermöglicht, die durch jede Phasenverschiebungszelle durchführte Phasenverschiebung unabhängig einzustellen, oder
- wenigstens ein Einstellmittel, das mehreren Phasenverschiebungszellen gemein ist, das eine identische Phasenverschiebung für diese Phasenverschiebungszellen durchführt, wobei die anderen Phasenverschiebungszellen durch weitere Einstellmittel eingestellt werden.

3. Oszillator (500, 600, 1000) nach einem der vorhergehenden Ansprüche, **dadurch gekennzeichnet, dass** eine Nebenphasenverschiebungszelle (512) einer gegebenen Stufe die gleiche Phasenverschiebung wie die Hauptphasenverschiebungszelle (306) der gleichen Stufe durchführt und der Ausgang einer Nebenphasenverschiebungszelle (512) einer gegebenen Stufe mit einem Eingang der Hauptphasenverschiebungszelle (306) der nächsten Stufe verbunden ist, wobei die Nebenphasenverschiebungszelle (512) der gegebenen Stufe das Nebensignal an die Hauptphasenverschiebungszelle (306) der nächsten Stufe liefert, wobei der Ausgang einer Hauptphasenverschiebungszelle (306) einer gegebenen Stufe mit einem Eingang der Nebenphasenverschiebungszelle (512) der nächsten Stufe verbunden ist, wobei die Hautphasenverschiebungszelle (306) der gegebenen Stufe das Hauptsignal an die Nebenphasenverschiebungszelle (512) der nächsten Stufe liefert.

4. Oszillator (500, 600, 1000) nach einem der vorhergehenden Ansprüche, **dadurch gekennzeichnet, dass** wenigstens eine Hauptphasenverschiebungszelle umfasst:
- einen ersten Multiplizierer (308), der ein erstes Signal liefert, das dem Produkt aus dem Hauptsignal und einer ersten Steuerspannung entspricht,
- einen zweiten Multiplizierer (310), der ein zweites Signal liefert, das dem Produkt aus dem Nebensignal und:
- einer zweiten Steuerspannung entspricht, wenn das Hauptsignal ein Sinus ist, wobei das Nebensignal dem um einen Wert von 90° voreilenden Hauptsignal entspricht, oder
- einer dritten Steuerspannung entspricht, wenn das Hauptsignal ein Kosinus ist, wobei das Nebensignal dem um einen Wert von 90° nacheilenden Hauptsignal entspricht,
- einen Addierer (312) zum Addieren der durch die Multiplizierer (308, 310) gelieferten ersten und zweiten Signale;
wobei die erste, die zweite und die dritte Steuerspannung dem Kosinus, dem Sinus bzw. dem -Sinus des einstellbaren Phasenverschiebungswertes, multipliziert mit der gleichen Konstanten, entsprechen.

5. Oszillator (500, 600, 1000) nach einem der vorhergehenden Ansprüche, **dadurch gekennzeichnet, dass**:
- der Ausgang einer Hauptphasenverschiebungszelle (306) einer gegebenen Phasenverschiebungsstufe mit einem Eingang der Nebenphasenverschiebungszelle (512) der nächsten Stufe verbunden ist,
- wobei jede Nebenphasenverschiebungszelle (512) umfasst:
- einen dritten Multiplizierer (520), der ein Signal liefert, das dem Produkt aus dem Nebensignal und der ersten Steuerspannung entspricht,
- einen vierten Multiplizierer (522), der ein Signal liefert, das dem Produkt
▪ aus dem Hauptsignal und der zweiten Steuerspannung entspricht, wenn das Signal ein Kosinus ist,
▪ aus dem Hauptsignal und der dritten Steuerspannung entspricht, wenn das Signal ein Sinus ist,
- einen Addierer (524) zum Addieren der durch den dritten und den vierten Multiplizierer (520, 522) gelieferten Signale und zum Bereitstellen des Nebensignals.

6. Oszillator nach einem der Ansprüche 4 oder 5, **dadurch gekennzeichnet, dass** wenigstens ein Multiplizierer einer Phasenverschiebungszelle (700) umfasst:
- einen Schaltkreis (702, 704), der vier Transistoren umfasst, die paarweise als differentielle Paare geschaltet sind und durch die Steuerspannungen gesteuert werden,
- eine Verstärkerschaltung (706, 708), die zwei als differentielle Paare geschaltete Transistoren umfasst.

7. Oszillator (1000) nach Anspruch 6, **dadurch gekennzeichnet, dass** zwei Multiplizierer von zwei Phasenverschiebungszellen einer gleichen Phasenverschiebungsstufe und die die gleichen Signale empfangen, umfassen:
- jeweils einen Schaltkreis (802, 804, 802', 804'), wobei jeder Schaltkreis (802, 804, 802', 804') vier Transistoren, die paarweise als differentielle Paare geschaltet sind, umfasst, und
- eine gemeinsame Verstärkerschaltung (806, 806'), die zwei als differentielle Paare geschaltete Transistoren umfasst.

8. Oszillator nach einem der Ansprüche 6 oder 7, **dadurch gekennzeichnet, dass** zwei Multiplizierer von zwei Phasenverschiebungszellen einer gleichen Phasenverschiebungsstufe und die unterschiedliche Signale empfangen, umfassen:
- jeweils eine Verstärkerschaltung (902, 904), wobei jede Verstärkerschaltung (902, 904) vier Transistoren, die paarweise als differentielle Paare geschaltet sind, umfasst, und
- einen gemeinsamen Schaltkreis (906), der zwei als differentielle Paare geschaltete Transistoren umfasst.

9. Oszillator (500, 600, 1000) nach einem der vorhergehenden Ansprüche, **dadurch gekennzeichnet, dass** ein Leistungsteiler (508, 518) einer jeden Phasenverschiebungszelle (306, 512) vorgeschaltet ist.

10. Oszillator (500, 600, 1000) nach einem der vorhergehenden Ansprüche, **dadurch gekennzeichnet, dass** er wenigstens einen Verstärker (108, 514, 806, 806'), der in jedem geschleiften System angeordnet ist, umfasst.

11. Oszillator nach einem der vorhergehenden Ansprüche, **dadurch gekennzeichnet, dass** wenigstens ein Resonator (106, 516) eine Übertragungsleitung umfasst.

12. Oszillator (500, 600) nach einem der vorhergehenden Ansprüche, **dadurch gekennzeichnet, dass** er in IC-Technologie realisiert ist.

13. Verwendung des Oszillators (500, 600) nach einem der vorhergehenden Ansprüche, auf dem Gebiet der Funkfrequenzen oder Mikrowellen oder auf dem Gebiet der Optik.

## Claims

1. An oscillator (500, 600, 1000) for generating an adjustable-frequency signal, said oscillator (500, 600, 1000) comprising:
- a first looped system (502, 602), called principal, said principal looped system comprising:
- a phase shift device (506, 604), called principal, comprising at least one phase shift stage (306), called principal, for shifting the phase of a signal, called principal, by an adjustable phase shift value, each phase shift stage (306) defining a level of phase shift, said principal signal being a cosine or a sine,
- a resonator (106), called principal, the input of which is connected to the output of said principal phase shift device (506, 604) and the output of which is connected to an input of said principal phase shift device (506, 604);
- a second looped system, called secondary, said secondary looped system comprising:
- a second phase shift device (510, 608), called secondary, comprising as many so-called secondary phase shift stages 512), connected in series, as there are principal phase shift stages (306), producing the phase shift of a signal, called secondary, by said phase shift value, and
- a second resonator (516), called secondary, the input of which is connected to the output of said secondary phase shift device (510, 608) and the output of which is connected to an input of said secondary phase shift device (510, 608) and to an input of said principal phase shift device (506, 604), and the output of the principal resonator (106) being connected to an input of said secondary phase shift device (510, 608),
said oscillator comprising at least one means for adjusting the phase shift produced by each phase shift stage by multiplication of two signals in quadrature by two signals, called control signals, and by summation the resulting signals;
**characterized in that**, for each phase shift stage of one of said looped systems:
- one of said signals in quadrature is the principal signal, and
- the other of said signals in quadrature is the secondary signal.

2. Oscillator according to claim 1, **characterized in that** the at least one means for adjusting the phase shift comprises:
- at least one means of adjustment common to all the phase shift stages, each of said phase shift stages producing an identical phase shift, or
- at least one means of adjustment associated with each phase shift stage and making it possible to adjust the phase shift produced by each phase shift stage independently, or
- at least one means of adjustment common to several phase shift stages, producing an identical phase shift for these phase shift stages, the other phase shift stages being adjusted by other means of adjustment.

3. Oscillator (500, 600, 1000) according to any one of the previous claims, **characterized in that** a secondary phase shift stage (512) of a given level produces the same phase shift as that of the principal phase shift stage (306) of the same level and the output of a secondary phase shift stage (512) of a given level is connected to an input of the principal phase shift stage (306) of the level following, said secondary phase shift stage (512) of said given level providing the secondary signal to said principal phase shift stage (306) of said following level, the output of a principal phase shift stage (306) of a given level is connected to an input of the secondary phase shift stage (512) of the following level, said principal phase shift stage (306) of said given level providing the principal signal to said secondary phase shift stage (512) of said following level.

4. Oscillator (500, 600, 1000) according to any one of the previous claims, **characterized in that** at least one principal phase shift stage comprises:
- a first multiplier (308) providing a first signal corresponding to the product of the principal signal and a first control voltage,
- a second multiplier (310) providing a second signal, corresponding to the product of the secondary signal, and:
- a second control voltage when said principal signal is a sine, said secondary signal corresponding to the principal signal advanced by a value of 90°, or
- a third control voltage when said principal signal is a cosine, said secondary signal corresponding to the principal signal delayed by a value of 90°;
- a adder (312) for adding said first and second signals provided by said multipliers (308, 310);
said first, second and third control voltages corresponding respectively to the cosine, sine and -sine of the adjustable phase shift value multiplied by the same constant.

5. Oscillator (500, 600, 1000) according to any one of the previous claims, **characterized in that**:
- the sortie of a principal phase shift stage (306) of a given level of phase shift is connected to an input of the secondary phase shift stage (512) of the following level,
- each secondary phase shift stage (512) comprising:
- a third multiplier (520) providing a signal corresponding to the product of the secondary signal and the first control voltage,
- a fourth multiplier (522) providing a signal corresponding to the product:
▪ of the principal signal and the second control voltage when said signal is a cosine,
▪ of the principal signal and the third control voltage when said signal is a sine,
- an adder (524) for adding the signals provided by said third and fourth multipliers (520, 522) and providing said secondary signal.

6. Oscillator according to any one of claims 4 or 5, **characterized in that** at least one multiplier of a phase shift stage (700) comprises:
- a switching circuit (702, 704) comprising four transistors connected two by two as differential pairs and controlled by the control voltages,
- an amplifier circuit (706, 708) comprising two transistors connected as a differential pair.

7. Oscillator (1000) according to claim 6, **characterized in that** two multipliers of two phase shift stages of the same level of phase shift and receiving the same signals comprise:
- a switching circuit (802, 804, 802', 804') each, each switching circuit (802, 804, 802', 804') comprising four transistors connected two by two as differential pairs and
- a common amplifier circuit (806, 806') comprising two transistors connected as a differential pair.

8. Oscillator according to any one of claims 6 or 7, **characterized in that** two multipliers of two phase shift stages of the same level of phase shift and receiving different signals comprise:
- an amplifier circuit (902, 904) each, each amplifier circuit (902, 904) comprising four transistors connected two by two as differential pairs and
- a common switching circuit (906) comprising two transistors connected as a differential pair.

9. Oscillator (500, 600, 1000) according to any one of the previous claims, **characterized in that** a power divider (508, 518) is arranged upstream of each phase shift stage (306, 512).

10. Oscillator (500, 600, 1000) according to any one of the previous claims, **characterized in that** it comprises at least one amplifier (108, 514, 806, 806') arranged in each looped system.

11. Oscillator according to any one of the previous claims, **characterized in that** at least one resonator (106, 516) comprises a transmission line.

12. Oscillator (500, 600) according to any one of the previous claims, **characterized in that** it is produced using integrated circuit technology.

13. Use of the oscillator (500, 600) according to any one of the previous claims in the radiofrequency or microwave frequency field or in the optical field.
